Europäisches Patentamt

European Patent Office

Office européen des brevets

(19)

(11) Publication number: **0 026 673**
**B1**

(12) **EUROPEAN PATENT SPECIFICATION**

(45) Date of publication of patent specification: **21.03.84**

(21) Application number: **80303456.0**

(22) Date of filing: **01.10.80**

(51) Int. Cl.³: **G 01 J 5/00, G 01 N 25/72,**
**G 01 K 1/02, G 01 R 31/28**

(54) **A method for measurement of temperature distribution over the surface of a sample, and a system for performing such measurement.**

(30) Priority: **02.10.79 JP 127041/79**

(43) Date of publication of application:
**08.04.81 Bulletin 81/14**

(45) Publication of the grant of the patent:
**21.03.84 Bulletin 84/12**

(84) Designated Contracting States:
**DE FR GB**

(56) References cited:
**IEEE MTT-S INTERNATIONAL MICROWAVE
SYMPOSIUM DIGEST; San Diego, California,
June, 21-23, 1977, New York, USA F.N. SECHI
et al.: "Computer-controlled infrared microscope
for thermal analysis of microwave transistors",
pages 143-146
IEEE TRANSACTIONS ON INDUSTRIAL
ELECTRONICS AND CONTROL
INSTRUMENTATION, vol. IECI-20, no. 4,
November 1973, New York, USA D.W.
BALLARD et al.: "Computer-based
thermographic displays and real-time
techniques", pages 200-205**

(73) Proprietor: **VLSI Technology Research Association
4-28, Mita 1-chome Minato-ku
Tokyo 108 (JP)**

(72) Inventor: **Kobayashi, Ikuro
3133-3-15-105, Kanai-cho Machida-shi
Tokyo 194-01 (JP)**
Inventor: **Shimizu, Kyozo c/o Nippon Electric
Company Limited
33-1, Shiba 5-chome Minato-ku
Tokyo 108 (JP)**

(74) Representative: **Bedggood, Guy Stuart et al,
Haseltine Lake & Co. Hazlitt House 28
Southampton Buildings Chancery Lane
London WC2A 1AT (GB)**

(56) References cited:
**IEEE, Nerem Record, Boston, November 6-8,
1973, vol. 15, US, Newton, New York, USA B.
STIEFELD: "Microcircuits-IR studies enhanced
by an interactive minicomputer system", pages
114-122**

Courier Press, Leamington Spa, England.

# A method for measurement of temperature distribution over the surface of a sample and a system for performing such measurement

This invention relates to a method for measurement of temperature distribution over the surface of a sample, and a system for performing such measurement.

Conventionally, for the measurement of the surface temperature of a sample of a material, the amount of radiated radiation, for example infrared radiation, is measured in order to determine the intensity of heat radiated from the surface of the material. The amount of radiated radiation is calibrated in terms of temperature. Since the amount of radiated radiation, at a specified temperature, differs for different materials, temperature calibration as mentioned above is conventionally required. Therefore, in order to calibrate the amount of radiated radiation to a temperature, it is necessary to know the radiation coefficient of radiated radiation of the sample to be measured.

In other words, first of all, it is necessary to previously determine the intensity of radiated heat which will be radiated at each temperature from a material having a radiation coefficient of 1.0. for example, a black radiation body. Then, intensity of radiated heat of a sample in respect of which measurement is to be made must be related to the heat intensity value of a sample having a radiation coefficient of 1.0. For example, if the radiation coefficient of the sample in respect of which measurement is to be made is taken to be $\alpha$, the above conversion can be effected on the basis of the equation:— radiated heat intensity $\times 1/\alpha$. Then, an actual temperature of the sample in respect of which measurement is to be made can be determined from the relationship between radiated heat intensity from that sample and the temperature of a material having a radiation coefficient of 1.0 determined previously.

The method mentioned above can be used to provide easily surface temperature distribution for sample consisting of a homogeneous material having a previously known radiation coefficient.

However, in the case of a sample consisting of a variety of regions of co-existing materials, such as the surface of an integrated circuit, if the radiation coefficient of each region at the surface of the sample is unknown, a surface temperature distribution cannot be obtained. This is a serious disadvantage of the conventional method. Moreover, it is very difficult to determine the radiation coefficient of each region on the surface of such a sample.

The article "Computer-Based Thermographic Displays and Real-Time Techniques" pages 200—205, IEEE Transactions on Industrial Electronics and Control Instrumentation, vol IECI-20, No. 4, November 1973, discloses infrared scanning, using microscope optics, of microelectronics componentry, e.g. a hybrid circuit, and the use of data gathered by the scanning to provide a thermographic display of the relative temperature profile across the circuit. To provide absolute temperature data, taking into account the wide variations in surface emissivity which can occur across the hybrid circuit, the hybrid circuit is first brought to a uniform temperature. Voltages proportional to scanned radiation output from selected points on the circuit, at the uniform temperature, are recorded under computer control. Then the circuit is placed in a specified operating condition (i.e. with specified voltage inputs) and scanned again. Measurements are taken again for the selected points under computer control. The results of the first scan are used to compute emissivity at each selected point. The computed emissivities are then used to calculate temperatures of the selected points from the measurements taken in the second scan.

The article "Microcircuits-IR studies enhanced by an interactive minicomputer system" pages 114—122, IEEE, Nerem Record, Boston, November 6—8, 1973. Vol 15, also discloses a computer based infrared scanning system in which emissivities at specified points are measured and stored in computer memory for later use to calculate temperatures.

The article "Computer-controlled infrared microscope for thermal analysis of microwave transistors" pages 143—146, IEEE MTT-S International Microwave Symposium Digest, San Diego, California, June 21—23, 1977, also discloses the use of a computer controlled infrared microscope for measuring temperature profiles of a device under test. Again, emissivities of discrete points on the sample under test are calculated from an infrared scan (or scans) of the device under test at a known temperature (or known temperatures). A previous infrared scan is carried out with the device biassed for normal operating conditions.

From the measured emissivities and from the infrared radiation measured in the scan of the device in its normal operating conditions a temperature profile of the device in its normal operating conditions can be obtained.

Emissivities can be measured more accurately if two or more known-temperature scans are effected.

According to one aspect of the present invention there is provided a method of measuring surface temperature distribution of a sample in a specified measuring condition in which the temperature condition of the sample is unknown in advance, comprising:

maintaining the sample in a first known-temperature condition and measuring amounts of radiation from each of a plurality of regions of the surface of the sample,

maintaining the sample in a second known-temperature condition, different from the first, and measuring amounts of radiation from each of the said plurality of regions,

maintaining the sample in the specified measuring condition and measuring amounts of radiation from each of the said plurality of regions, characterised by:—

determining the temperature of each of the said plurality of regions, when the sample is in the specified measuring condition, from the amounts of radiation from each of the said plurality of regions in the first and second known-temperature conditions and from the amounts of radiation from each of the said plurality of regions in the specified measuring conditions, without employing radiation coefficients for the said plurality of regions, on the basis of the relationship:—

$$T_0=[(T_2-T_1)/(P_2-P_1)] \cdot (P_0-P_1)+T_1$$

where $T_0$ is the temperature of the region under consideration when the sample is in the specified measuring condition, $T_1$ and $T_2$ are the known temperatures of the first and second known-temperature conditions of that region, $P_0$ is the amount of radiation from that region of the said plurality when the sample is in the specified measuring condition, and $P_1$ and $P_2$ are the amounts of radiation from that region in the first and second known-temperature conditions.

According to another aspect of the present invention there is provided a system for measuring the surface temperature distribution of a sample in a specified measuring condition in which the temperature condition of the sample is unknown in advance, the system comprising a detector operable to detect amounts of radiation from each of a plurality of regions of the surface of the sample, and a condition setting unit operable to maintain the sample in each of at least two different known-temperature conditions,

characterised in that the system comprises an operations unit operable, in dependence upon signals from the detector representative of amounts of radiation from each of the said plurality of regions in each of the two known-temperature conditions and signals representative of amounts of radiation from each of the said plurality of regions in the specified measuring condition, to determine the temperature of each of the said plurality of regions in the specified measuring condition, without employing radiation coefficients for the said plurality of regions, on the basis of the relationship:—

$$T_0=[(T_2-T_1)/(P_2-P_1)] \cdot (P_0-P_1)+T_1$$

where $T_0$ is the temperature of the region under consideration when the sample is in the specified measuring condition, $T_1$ and $T_2$ are the known temperatures of the two known-temperature conditions, $P_0$ is the amount of radiation from that region of the said plurality when the sample is in the specified measuring condition, and $P_1$ and $P_2$ are the amounts of radiation from that region in the two known-temperature conditions.

This invention can provide a method for easily measuring the temperature distribution over a sample surface, and a system for the same.

This invention can provide a method for measuring temperature distribution over a sample surface which does not require knowledge of the radiation coefficients of radiated heat, and a system for the same.

This invention can provide a method for measuring temperature distribution over a sample surface which does not require knowledge of the radiation coefficients of radiated radiation, and a system for the same.

This invention can provide a method for easily measuring temperature distribution over a sample surface consisting of a plurality of co-existing materials having different radiation coefficients for radiated radiation (e.g. infrared radiation) at temperatures concerned, and a system for the same.

This invention can provide a method for easily measuring temperature distribution over a surface of a semi-conductor integrated circuit, and a system for the same.

Briefly, in an embodiment of this invention, the surface temperature distribution of a sample having a plurality of coexisting regions of materials of different radiation coefficients is measured by first maintaining the sample at known temperatures, obtaining the amounts of radiation radiated respectively from a plurality of subdivided narrower (small) regions of the sample surface at least at the two known temperatures, obtaining temperature coefficients for the amounts of radiated radiation from the respective regions of the surface, and measuring unknown temperatures of the respective regions from the amounts of radiation radiated respectively from those regions when the sample is placed under measuring conditions, and from the temperature coefficients.

Reference is made, by way of example, to the accompanying drawings, in which:—

Figure 1 is a graph indicating a relationship between the amount of radiated infrared radiation and temperature for assistance in explanation of the basic idea of this invention,

Figure 2 is a schematic block diagram of a measuring system embodying this invention, and

Figure 3 is a plan view of the surface of an integrated semiconductor circuit, indicating an example of a plurality of regions on the surface of the circuit in respect of which measurements are taken in an embodiment of this invention.

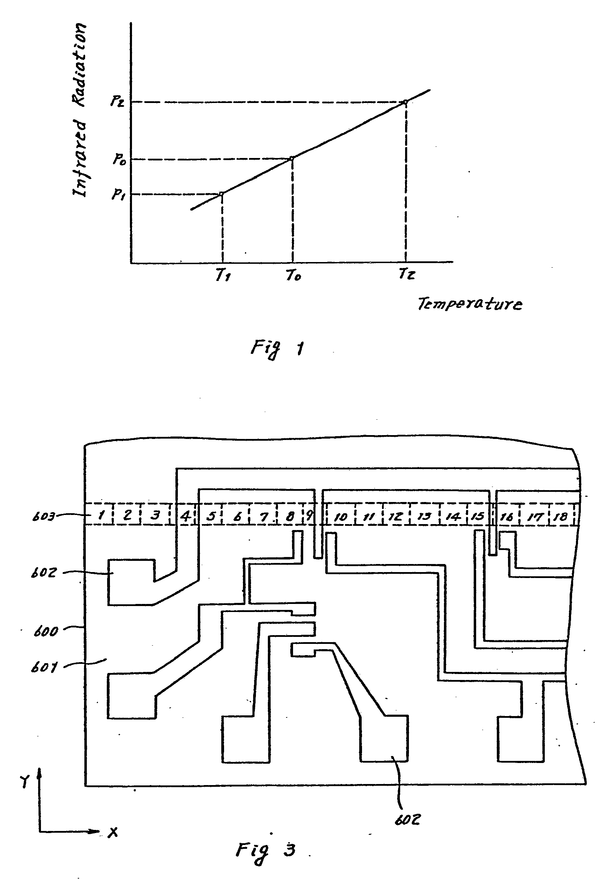

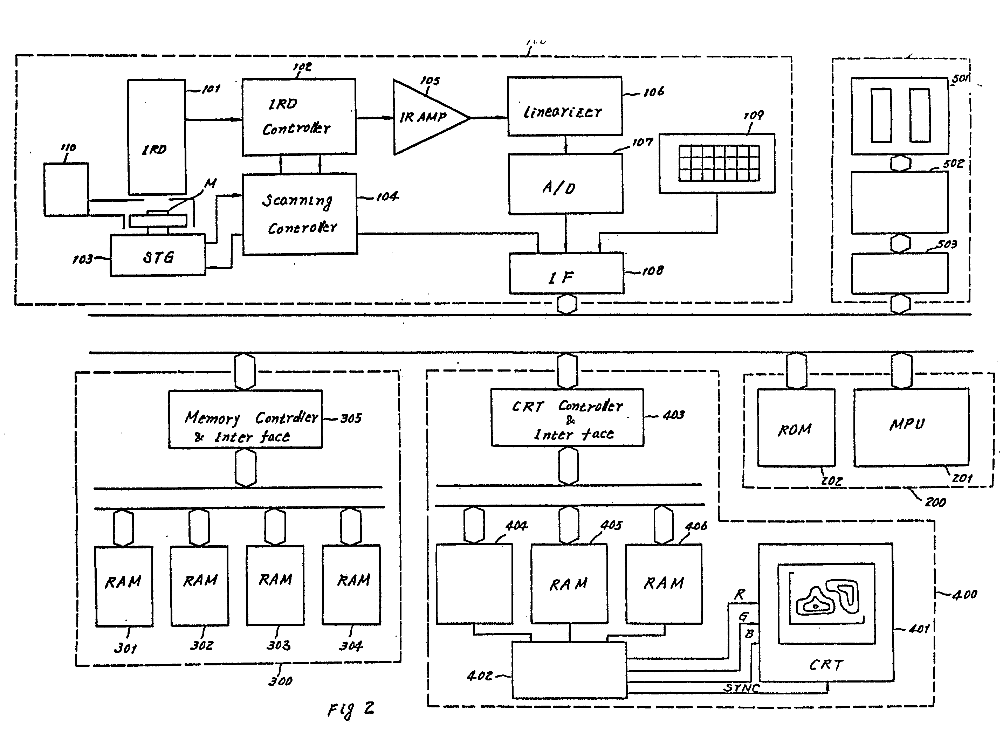

Figure 1 is a graph indicating the relationship between the amount of infrared radiation from, and the temperature of, a sample, for explaining the basic features of this invention. In this invention, the amount of radiation, particularly the amount of infrared radiation, radiated from the surface of a sample is detected in order to obtain a measure of radiated heat intensity of the surface of the sample. Thus, the following explanation is given on the basis of the amount of infrared radiation, instead of radiated heat intensity.

According to the basic idea of this invention, a sample is first kept at a first known temperature $T_1$ and the amount of the infrared radiation $P_1$ radiated from the surface of the sample is detected. Moreover, the sample is then kept at a second known temperature $T_2$ and the amount of infrared radiation $P_2$ radiated from the surface of the sample is detected. Then, a ratio of the difference $(P_2-P_1)$ of the two amounts of infrared radiation and the difference $(T_2-T_1)$ of the two known temperatures is calculated, and thereby the ratio of infrared radiation to temperature, namely the temperature coefficient, can be obtained. Then, the sample is set in a measuring condition and the amount of infrared radiation $P_0$ radiated from the sample surface is obtained. The desired unknown temperature $T_0$ is obtained, for example, from the following equation, by making use of the previously obtained temperature coefficient of the infrared radiation.

$$(P_2-P_1)/(T_2-T_1)=(P_0-P_1)/(T_0-T_1)$$

$$T_0=[(T_2-T_1)/(P_2-P_1)] \cdot (P_0-P_1)+T_1 \qquad (a)$$

As explained above, the basic idea of this invention utilizes the property that amount of infrared radiation and temperature are approximately proportional. Strictly speaking, the amount of infrared radiation and the temperature are not in a strict proportional relationship, but they can be put into an approximate proportional relationship by using a linearizer.

As will be understood from the above explanation, the surface temperature of a sample can be detected according to this invention without knowledge of a radiation coefficient for infrared radiation of materials forming the sample. In addition, to obtain a temperature distribution it is required only to detect the amount of infrared radiation for a subdivided plurality of regions on the surface of the sample. Moreover, since likely temperatures of unknown temperature regions can generally be forecast to a certain degree, it is desirable to set the first and second known temperatures $T_1$ and $T_2$ to the lower and upper ends of such temperature regions.

A more accurate temperature coefficient can be obtained by measuring the amount of infrared radiation for known temperatures other than the first and second known temperatures $T_1$, $T_2$ in order to obtain a temperature coefficient for the amount of infrared radiation.

A surface temperature distribution measuring system embodying this invention utilizing a measuring method embodying this invention will be explained hereunder.

Figure 2 is a block diagram indicating the organisation of the measuring system.

The system has a detector 100 which detects amounts of infrared radiation, a controller 200 which controls the system as a whole and performs operations for obtaining temperature coefficients of infrared radiation and unknown sample temperatures, a memory unit 300 which stores the distribution of infrared radiation (over the surface of a sample) and is used at the time of operation, a display unit 400 which displays the distribution of amounts of infrared radiation and the distribution of unknown temperatures over the surface of a sample, and an external memory unit 500 which stores various kinds of information.

The detector 100 comprises an infrared radiation detector 101 for measuring amounts of infrared radiation from the surface of a sample M, an infrared radiation detector controller 102 which controls the detector 101, a movable scanner 103, movable in at least X and Y directions, on which the sample M is mounted, and a scanning controller 104, which controls the movable scanner. The amounts of infrared radiation radiated from each of a plurality of narrowly subdivided regions on the surface of the sample can be measured with these units.

The infrared radiation detector 101 is provided for example, with a light receiving element, which converts a received amount of infrared radiation into an electrical signal. Such electrical signal is then amplified by an amplifier 105 and input to a linearizer 106.

Strictly speaking, amount of infrared radiation and temperature are not in a strict linear relationship, and amount of infrared radiation and the resultant electrical signal are also not always in a strict linear relationship due to the characteristics of a light receiving element. Therefore, linearizer 106 is provided in order to make linear the relationship between temperature and electrical signal representing an amount of infrared radiation.

An electrical signal thus linearized is converted into a digital signal by A/D converter 107.

Figure 3 is a plan view indicating an example of a plurality of regions on ghe surface of a semiconductor integrated circuit used as a sample. In a semiconductor integrated circuit, patterns are usually formed, on the surface of a silicon semiconductor substrate 600, with a variety of materials. In Figure 3, 601 is the surface of an $SiO_2$ film and 602 is an A1 wiring and electrode pattern.

Such a semiconductor integrated circuit is mounted on the movable scanner 103 as a sample M and the surface of such a sample M is scanned as it is moved in X and Y directions. The scanning is carried out, for example, from left to right as indicated by the broken line pattern 603 in Fig. 3, and thereby amounts to infrared radiation radiated respectively from the narrowly (small) subdivided regions 1, 2, 3, ...., 18 are detected and digital signals representing those amounts are generated. Since a semiconductor integrated circuit surface is very small, an infrared radiation microscope is used for detection of the infrared radiation of each region. Digital signal information pertaining to each region thus obtained is stored in memory 300 via an interface 108.

109 is a keyboard for giving various pieces of information to detector 100 from the outside. In addition, 110 is a condition setting unit which can put the sample M into a known temperature condition or into a measuring condition and it is provided with a heater in order to keep the sample M at a known temperature.

The controller 200 comprises a microprocessor unit 201 and a read-only-memory ROM 202 which stores control programs for arithmetic operations etc.

The memory 300 comprises four RAM's 301, 302, 303, 304, and a memory controller 305 which controls those RAMs. RAM 301 is used for arithmetic operations, RAM 302 stores various pieces of information regarding the plurality of regions on the sample surface and amounts of infrared radiation at known temperature $T_1$, RAM 303 stores such information in relation to known temperature $T_2$, and RAM 304 stores such information under a measuring condition.

Display unit 400 comprises a cathode ray tube CRT 401, for displaying pictures, and a video signal generator 402 which sends video signals R, G, B and SYNC to 401. The video signals R, G, B are colour video signals. 403 is a CRT controller which controls CRT 401 etc. 404 is a controller for the display of characters. 405, 406 are RAMs for temporarily storing display information sent from the RAMs 301, 302, 303, 304 of the memory 300.

An external memory 500 has, for example, a floppy disk 501, a controller 502 and an interface 503.

Digital signal information concerning infrared radiation corresponding to respective differently positioned ones of the plurality of regions of the sample surface obtained by the detector 100 is stored in the RAMs 301, 302, 303, and 304. Arithmetic operations for determining an unknown temperature distribution are carried out after the regional information in the RAMs and the plurality of regions on the sample surface are mutually "aligned" so that they correspond on a one-to-one basis. The alignment can be made, for example, by storing a pair of data values required for arithmetic operations, such as $P_1$ and $P_2$ or $P_1$ and $P_0$, in the RAMs 405, 406 and by displaying such data on the CRT 401.

The operations which are carried out in order to effect the above mentioned arithmetic operations will be explained hereunder.

A pair of data values relating to known temperatures are shifted into the RAMs 405, 406 from the RAMs 302, 303 and then alignment is performed on the CRT 401. At this time, the RAM 301 is used for correcting any error of alignment. Upon completion of alignment, the arithmetic operations for obtaining difference between a pair of infrared radiation amounts $P_1$, $P_2$ are performed for each region among the plurality of regions of the sample surface, and the result is stored in the external memory 500. The result is $(P_2-P_1)$ and the temperature coefficient of infrared radiation amount can be obtained easily from this result and $(T_2-T_1)$. Then, the information relating to a digital signal representing $P_0$, an infrared radiation amount obtained under a specified measuring condition, is shifted to RAM 304 while the information $P_1$ relating to the known temperature $T_1$, is shifted to the RAMs 405, 406. Thus, alignment is also performed as explained above. The result $(P_0-P_1)$ is stored in the external memory 500. Finally, from the information values $(P_2-P_1)$, $(P_0-P_1)$ for each region unknown temperatures $T_0$ of respective regions are obtained on the basis of the abovementioned equation (a), and stored in the RAM 405. Thereby, a surface temperature distribution diagram is displayed on the CRT 401, in different colours for example.

A specified measuring condition means, for example, in the case of a semiconductor integrated circuit, an operating condition for the integrated circuit established by applying a current to the circuit.

A knowledge of surface temperature distribution of a semiconductor integrated circuit, for example, under its operating conditions, can be used for failure analysis and testing etc, and can thereby provide for improvement in and control of manufacture of semiconductor integrated circuits for example.

In the embodiment described above an infrared radiation microscope is used in order to obtain the surface temperature distribution of a small sample such as a semiconductor integrated circuit. Alternatively, a telescope may be used for detecting radiated heat or light for the purpose of scanning a sample to obtain a temperature distribution for a large sample consisting of coexisting materials of different radiation coefficients.

As explained previously, according to this invention, surface temperature distribution can be obtained without knowledge of the radiation coefficients of radiated heat, due to infrared radiation etc., of the sample surface. In addition, according to this invention, temperature distribution of the surface of a sample consisting of a coexisting plurality of materials having different radiation coefficients of radiated heat can easily be measured. Moreover, according to this invention, temperature distribution on the surface of a semiconductor integrated circuit can be easily measured and the result can be effectively used for failure analysis and testing of integrated circuits.

The above description has been given with reference to a case in which infrared radiation is particularly detected. Alternatively, light radiation may be detected or radiated heat.

Thus, this invention relates to a method for measuring surface temperature distribution of a sample which can be used even when a plurality of materials having different radiation factors at the specified temperatures concerned coexist, and a system for the same.

In the measuring method, the sample is first kept at a known temperature, and the amounts of, for example, infrared radiation radiated from a plurality of narrow regions divided from one another and arrayed over the surface of the sample are obtained. This measurement is performed at least twice, at two different known temperatures, and therefrom temperature coefficients for the amounts of infrared radiation from each of the plurality of subdivided regions on the surface of the sample are obtained. Succeedingly, with the sample being held under a measuring condition, the amounts of infrared radiation radiated from the plurality of regions on the surface of the sample are measured. On the basis of such amounts of infrared radiation and the temperature coefficients, respective unknown temperatures of the plurality of regions subdivided on the surface of the sample can be determined.

## Claims

1. A method of measuring surface temperature distribution of a sample in a specified measuring condition in which the temperature condition of the sample is unknown in advance, comprising:

maintaining the sample in a first known-temperature condition and measuring amounts of radiation from each of a plurality of regions of the surface of the sample,

maintaining the sample in a second known-temperature condition, different from the first, and measuring amounts of radiation from each of the said plurality of regions,

maintaining the sample in the specified measuring condition and measuring amounts of radiation from each of the said plurality of regions, characterised by:—

determining the temperature of each of the said plurality of regions, when the sample is in the specified measuring condition, from the amounts of radiation from each of the said plurality of regions in the first and second known-temperature conditions and from the amounts of radiation from each of the said plurality of regions in the specified measuring condition, without employing radiation coefficients for the said plurality of regions, on the basis of the relationship:—

$$T_0=[(T_2-T_1)/(P_2-P_1)] \cdot (P_0-P_1)+T_1$$

where $T_0$ is the temperature of the region under consideration when mpe sample is in the specified measuring condition, $T_1$ and $T_2$ are the known temperatures of the first and second known-temperature conditions of that region. $P_0$ is the amount of radiation from that region of the said plurality when the sample is in the specified measuring condition, and $P_1$ and $P_2$ are the amounts of radiation from that region in the first and second known-temperature conditions.

2. A system for measuring the surface temperature distribution of a sample in a specified measuring condition in which the temperature condition of the sample is unknown in advance, the system comprising a detector operable to detect amounts of radiation from each of a plurality of regions of the surface of the sample, and a condition setting unit operable to maintain the sample in each of at least two different known-temperature conditions, characterised in that the system comprises an operations unit operable, in dependence upon signals from the detector representative of amounts of radiation from each of the said plurality of regions in each of the two known-temperature conditions and signals representative of amounts of radiation from each of the said plurality of regions in the specified measuring condition, to determine the temperature of each of the said plurality of regions in the specified measuring condition, without employing radiation coefficients for the said plurality of regions, on the basis of the relationship:—

$$T_0=[(T_2-T_1)/(P_2-P_1)] \cdot (P_0-P_1)+T_1$$

where $T_0$ is the temperature of the region under consideration when the sample is in the specified measuring condition, $T_1$ and $T_2$ are the known temperatures of the two known-temperature conditions, $P_0$ is the amount of radiation from that region of the said plurality when the sample is in the specified measuring condition, and $P_1$ and $P_2$ are the amounts of radiation from that region in the two known temperature conditions.

3. A system as claimed in claim 2, wherein the condition setting unit comprises a heater.

4. A system as claimed in claim 2 or 3, characterised in that the detector is provided with scanning means for scanning the surface of the sample.

5. A system as claimed in claim 4, wherein the scanning means is capable of mounting therein the sample, and has a scanner, for scanning the surface of the sample, moveable in at least X and Y directions.

6. A system as claimed in any one of claims 2 to 5, further comprising a display unit operable for identifying the amounts of radiation and temperatures, in the specified measuring condition, with respective regions of the surface of the sample.

7. A system as claimed in claim 6, wherein the display unit is operable to provide a colour display.

8. A method as claimed in claim 1, or a system as claimed in any one of claims 2 to 7, wherein the radiation the amounts of which is measured is infrared radiation.

9. A method as claimed in claim 1, or a system as claimed in any one of claims 2 to 7, wherein the sample comprises a plurality of different materials having different radiation coefficients, for the radiation the amounts of which are measured, at the same temperature.

10. A method or a system, as the case may be, as claimed in claim 9, wherein the sample is an integrated circuit element.

11. A method or a system, as the case may be, as claimed in claim 10, wherein the specified measuring condition is an operating condition of the integrated circuit element when a current is applied thereto.

## Revendications

1. Procédé de mesure de la répartition des températures superficielles d'un échantillon dans des conditions spécifiées de mesure dans lesquelles l'état de température de l'échantillon n'est pas connu à l'avance, qui consiste à:

maintenir l'échantillon dans des premières conditions de température connue et mesurer les quantités de rayonnement émanant le chacune de plusieurs régions de la surface de l'échantillon,
maintenir l'échantillon dans des deuxièmes conditions de température connue, différentes des premières conditions, et mesurer les quantités de rayonnement émanant de chacune desdites régions.
maintenir l'échantillon dans des conditions spécifiées de mesure et mesurer les quantités de rayonnement émanant de chacune desdites régions, caractérisé par l'opération suivante:
déterminer la température de chacune desdites régions, lorsque l'échantillon se trouve dans les conditions spécifiées de mesure, à partir des quantités de rayonnement émanant de chacune desdites régions dans les premières et les deuxièmes conditions de température connue et à partir des quantités de rayonnement émanant de chacune desdites régions dans les conditions spécifiées de mesure, sans faire appel aux coefficients de rayonnement desdites régions, sur la base de la relation:

$$T_0 = [(T_2 - T_1)/(P_2 - P_1)] \cdot (P_0 - P_1) + T_1$$

où $T_0$ est la température de la région considérée lorsque l'échantillon se trouve dans les conditions spécifiées de mesure, $T_1$ et $T_2$

sont les températures connues des premières et des deuxièmes conditions de température connue de cette région, $P_0$ est la quantité de rayonnement émanant de cette région lorsque l'échantillon se trouve dans les conditions spécifiées de mesure, et $P_1$ et $P_2$ sont les quantités de rayonnement émanant de cette région dans les premières et les deuxièmes conditions de température connue.

2. Dispositif de mesure de la distribution des températures superficielles d'un échantillon dans des conditions spécifiées de mesure dans lesquelles l'état de température de l'échantillon n'est pas connu à l'avance, le dispositif comprenant un détecteur avant pour fonction de mesurer les quantités de rayonnement émanant de chacune de plusieurs régions de la surface de l'échantillon, et une unité de fixation de conditions ayant pour fonction de maintenir l'échantillon dans chacun d'au moins deux ensembles différents de conditions de température connue, caractérisé en ce qu'il comprend une unité d'opérations ayant pour fonction, sous commande de signaux du détecteur représentant des quantités de rayonnement émanant de chacune desdites régions dans chacun des deux ensembles de conditions de température connue et de signaux représentant des quantités de rayonnement émanant de chacune desdites régions dans les conditions spécifiées de mesure, de déterminer la température de chacune desdites régions dans les conditions spécifiées de mesure, sans employer les coefficients de rayonnement desdites régions, sur la base de l'équation:

$$T_0 = [(T_2 - T_1)/(P_2 - P_1)] \cdot (P_0 - P_1) + T_1$$

où $T_0$ est la température de la région considérée lorsque l'échantillon est dans les conditions spécifiées de mesure, $T_1$ et $T_2$ sont les températures connues des deux ensembles de conditions de température connue, $P_0$ est la quantité de rayonnement émanant de cette région lorsque l'échantillon est dans les conditions spécifiées de mesure, et $P_1$ et $P_2$ sont les quantités de rayonnement émanant de cette région dans les deux ensembles de conditions de température connue.

3. Dispositif selon la revendication 2, où l'unité de fixation de conditions comprend un élément chauffant.

4. Dispositif selon la revendication 2 ou 3, caractérisé en ce que le détecteur est doté d'un moyen de balayage permettant de balayer la surface de l'échantillon.

5. Dispositif selon la revendication 4, où le moyen de balayage est en mesure d'assurer le montage de l'échantillon et possède un dispositif de balayage, permettant de balayer la surface de l'échantillon, qui est mobile suivant au moins des directions X et Y.

6. Dispositif selon l'une quelconque des revendications 2 à 5, comprenant en outre une unité d'affichage ayant pour fonction de permettre l'identification des quantités de rayonnement et des températures, dans les conditions spécifiées de mesure, à des régions respectives de la surface de l'échantillon.

7. Dispositif selon la revendication 6, où l'unité d'affichage est en mesure de produire un affichage en couleur.

8. Procédé selon la revendication 1, ou dispositif selon l'une quelconque des revendications 2 à 7, où le rayonnement dont les quantités sont mesurées est un rayonnement infrarouge.

9. Procédé selon la revendication 1, ou dispositif selon l'une quelconque des revendications 2 à 7, où l'échantillon comprend plusieurs matériaux différents possédant des coefficients de rayonnement différents, pour le rayonnement dont les quantités sont mesurées, à la même température.

10. Procédé ou dispositif, selon le cas, selon la revendication 9, où l'échantillon est un élément de circuit intégré.

11. Procédé ou dispositif, selon le cas, selon la revendication 10, où les conditions spécifiées de mesure sont les conditions de fonctionnement de l'élément de circuit intégré lorsqu'un courant lui est appliqué.

**Patentansprüche**

1. Verfahren zur Messung der Oberflächentemperaturverteilung eines Musters in einem spezifizierten Meßzustand, in dem der Temperaturzustand des Musters vorher unbekannt ist, bei welchem

das Muster in einem ersten Zustand bekannter Temperatur gehalten und die Strahlungsmengen von jeder einer Mehrzahl von Zonen der Oberfläche des Musters gemessen werden,

das Muster in einem zweiten Zustand bekannter Temperatur, welche von dem ersten verschieden ist, gehalten und Strahlungsmengen von jeder der genannten mehreren Zonen gemessen werden,

das Muster in dem spezifizierten Meßzustand gehalten und Strahlungsmengen von jeder der genannten mehreren Zonen gemessen werden, dadurch gekennzeichnet, daß die Temperatur von jeder der genannten mehreren Zonen, wenn das Muster sich in dem spezifizierten Meßzustand befindet,

aus den Strahlungsmengen jeder der genannten mehreren Zonen in dem ersten und zweiten Zustand bekannter Temperatur und aus den Strahlungsmengen jeder der mehreren Zonen in dem spezifizierten Zustand, ohne Verwendung der Strahlungskoeffizienten der genannten mehreren Zonen, auf der Basis der folgenden Relation bestimmt wird:

$$T_0 = [(T_2 - T_1)/(P_2 - P_1)] \cdot (P_0 + P_1) + T_1$$

wobei $T_0$ die Temperatur der betrachteten Zone ist, wenn das Muster sich in dem spezifizierten Meßzustand befindet, $T_1$ und $T_2$ die bekannten Temperaturen des ersten und des zweiten bekannten Temperaturzustands dieser Zone sind, $P_0$ die Strahlungsmenge dieser von mehreren Zonen ist, wenn das Muster sich in dem spezifizierten Meßzustand befindet, und $P_1$ und $P_2$ die Strahlungsmengen von der Zone in dem ersten Zustand und in dem zweiten Zustand bekannter Temperatur sind.

2. System zum Messen der Oberflächentemperaturverteilung eines Musters in einem spezifizierten Meßzustand, in dem der Temperaturzustand des Musters vorher unbekannt ist,

mit einem Detektor, welcher die Strahlungsmengen von jeder von mehreren Zonen auf der Oberfläche des Musters messen kann, und mit einer Zustandseinstelleinheit, welche das Muster in jedem von wenigstens zwei verschiedenen Zuständen bekannter Temperatur halten kann,

dadurch gekennzeichnet, daß das System eine Arbeitseinheit umfaßt, welche in Abhängigkeit von Signalen von dem Detektor, welche repräsentativ für die Strahlungsmengen von jeder der genannten mehreren Zonen, in jedem der beiden Zustände bekannter Temperatur sind, und Signalen, welche repräsentativ sind für die Strahlungsmengen von jeder der mehreren Zonen in dem spezifizierten Meßzustand, die Temperatur von jeder der genannten mehreren Zonen in dem spezifizierten Meßzustand, ohne Verwendung der Strahlungskoeffizienten für die genannten mehreren Zonen, auf der Basis der folgenden Relation bestimmt:

$$T_0 = [(T_2 - T_1)/(P_2 - P_1)] \cdot (P_0 - P_1) + T_1$$

in welcher $T_0$ die Temperatur der betrachteten Zone ist, wenn das Muster sich in dem spezifizierten Meßzustand befindet, $T_1$ und $T_2$ die bekannten Temperaturen der beiden Zustände bekannter Temperatur sind, $P_0$ die Strahlungsmenge von der Zone der genannten Mehrzahl von Zonen ist, wenn das Muster sich in dem spezifizierten Meßzustand befindet, und $P_1$ und $P_2$ die Strahlungsmengen der Zone in den beiden Zuständen bekannter Temperatur sind.

3. System nach Anspruch 2, bei welchem die Zustandseinstelleinheit einen Heizapparat umfaßt.

4. System nach Anspruch 2 oder 3, dadurch gekennzeichnet, daß der Detektor eine Abtasteinrichtung zum Abtasten der Oberfläche des Musters umfaßt.

5. System nach Anspruch 4, bei welchem die Abtasteinrichtung das Muster in sich aufnehmen kann und einen Abtaster zum Abtasten der Oberfläche des Musters umfaßt, welcher wenigstens in X- und Y-Richtung bewegbar ist.

6. System nach einem der Ansprüche 2 bis 5, welches ferner eine Anzeigeeinrichtung umfaßt, welche die Strahlungsmengen und die Temperaturen in dem spezifizierten Meßzustand bezüglich der Zonen der Oberfläche des Musters anzeigen kann.

7. System nach Anspruch 6, bei welchem die Anzeigeeinheit eine Farbanzeige liefern kann.

8. Verfahren nach Anspruch 1 oder System nach einem der Ansprüche 2 bis 7, bei welchem die Strahlung, deren Mengen gemessen werden, infrarote Strahlung ist.

9. Verfahren nach Anspruch 1 oder System nach einem der Ansprüche 2 bis 7, bei welchem das Muster eine Anzahl von verschiedenen Materialien umfaßt, welche für die Strahlung, deren Mengen gemessen werden, bei derselben Temperatur, verschiedene Strahlungskoeffizienten aufweisen.

10. Verfahren oder System, wie es der Fall sein mag, nach Anspruch 9, bei welchem das Muster ein integriertes Schaltungselement ist.

11. Verfahren oder System, wie es der Fall sein mag, nach Anspruch 10, bei welchem der spezifizierte Meßzustand ein Betriebzustand des integrierten Schaltungselementes ist, wenn diesem ein Strom zugeführt wird.

# 0 026 673

Fig 1

Fig 3

Fig 2